# EUROPÄISCHE PATENTSCHRIFT

(11) **EP 1 518 272 B1**
(45) Veröffentlichungstag und Bekanntmachung des Hinweises auf die Patenterteilung: **29.04.2009**
(21) Anmeldenummer: 03761414.6
(22) Anmeldetag: 12.06.2003
(51) Int. Cl.: H01L 23/485

(54) **UNTER EIN PAD INTEGRIERTE HALBLEITERSTRUKTUR**
SEMICONDUCTOR STRUCTURE INTEGRATED UNDER A PAD
STRUCTURE DE SEMI-CONDUCTEUR INTEGREE EN-DESSOUS D'UN METAL DE CONTACT

(30) Priorität: 01.07.2002 DE 10229493
(43) Veröffentlichungstag der Anmeldung: 30.03.2005
(73) Patentinhaber: Infineon Technologies AG, 81669 München (DE)
(72) Erfinder: BAUER, Robert, 85665 Moosach (DE); ERTLE, Werner, 85579 Neubiberg (DE); FROHNMÜLLER, Till, 84028 Landshut (DE); GOLLER, Bernd, 83624 Otterfing (DE); GREIDERER, Reinhard, 80803 München (DE); NAGLER, Oliver, 81827 München (DE); SCHMECKEBIER, Olaf, 81373 München (DE); STADLER, Wolfgang, 80538 München (DE)
(74) Vertreter: Karl, Frank
(86) Internationale Anmeldenummer: PCT/DE2003/001955
(87) Internationale Veröffentlichungsnummer: WO 2004/004002

(56) Entgegenhaltungen:
- EP-A- 1 143 513
- US-A- 5 751 065
- US-A1- 2001 010 408

## Beschreibung

Die Erfindung betrifft eine integrierte Halbleiterstruktur mit einem Substrat, mindestens einem auf dem Substrat liegenden Halbleiterelement, einem Padmetall mit einer Fläche, einer Vielzahl von Metallschichten (bzw. Metallisierungslagen), die zwischen dem Padmetall und dem Substrat liegen und einer Vielzahl von Isolationsschichten, die die Metallschichten voneinander trennen, wobei das Padmetall sich zumindest über einen Teil des mindestens einen Halbleiterelementes erstreckt.

Eine solche Halbleiterstruktur ist beispielsweise aus der US 6,207,547 bekannt.

Ein wichtiger Aspekt bei der Herstellung von integrierten Halbleiterstrukturen ist die elektrische Kontaktierung (Bonden) der Halbleiterelemente, die sich innerhalb der Halbleiterstruktur befinden. Hierbei wird über Kontaktinseln der elektrische Kontakt zwischen Gehäusekontakten (PINs) und den Halbleiterelementen hergestellt. Die Kontaktinseln sind metallische Bereiche (Padmetall), die mit den Halbleiterelementen und Metallschichten elektrisch verbunden sein können. Aufgrund der aktuell verwendeten Bonding-Prozesse haben die Padmetalle eine relativ große Ausdehnung in der Halbleiterstruktur im Vergleich zu den Dimensionen der darunter liegenden Halbleiterelemente. Das Padmetall bedeckt also einen bedeutenden Bereich der Oberfläche eines Chips, sodass der Bereich, der unterhalb des Padmetalls liegt, einen deutlichen Anteil am Chipvolumen ausmacht.

Beim Bonden der Halbleiterstruktur wird eine große mechanische Belastung auf das Padmetall ausgeübt. Diese Belastung bringt die Gefahr mit sich, dass Strukturen, die unter dem Padmetall angeordnet sind, beschädigt werden. So kann die oberste Isolationsschicht, die direkt unterhalb des Padmetalls verläuft, Risse erhalten, die, aufgrund einer Verletzung der Passivierung der Halbleiterstruktur, zu Leckströmen führen. Zum anderen müssen Halbleiterelemente, beispielsweise aktive Strukturen wie MOS-Transistoren, die ein relativ dünnes GateOxid aufweisen, aus Zuverlässigkeitsgründen unbedingt vor zu starken Druck geschützt werden. Daher wurden früher keine Halbleiterelemente unterhalb des Padmetalls platziert, um Verletzungen zu vermeiden. Dies hat zur Folge, dass ein außerordentlich großer Flächenverlust des Chips in Kauf genommen wird.

Die EP 1 017 098 A2 schlägt eine Kombination aus einer stressabsorbierenden Metallschicht und einer mechanisch gestärkten elektrischen Isolationsschicht, sowie eine ausreichende Dicke dieser beiden Schichten vor, sodass zumindest ein Teil des Halbleiterelementes sich direkt unterhalb des Padmetalls erstrecken darf. Hierdurch wird jedoch nur eine geringfügige Reduktion des Flächenbedarfs auf der Chipoberfläche erreicht.

Aus der eingangs erwähnten US 6,207,547 ist es bekannt, eine strukturierte Zwischenschicht zwischen Padmetall und oberster Metallebene, zur Stabilisation und zum Schutz der darunterliegenden aktiven Schaltungen, einzuführen. Hierdurch wird erreicht, dass Strukturen mit Gateoxid, beispielsweise MOS-Transistoren, direkt unterhalb des Padmetalls platziert werden können. Die Herstellung solch einer strukturierten Zwischenschicht verlangt jedoch einen extra angepassten und komplizierten Herstellungsprozess.

Aus dem nächstkommenden Stand der Technik EP 1 143 513 A1, Fig. 6, ist ein integrierter Schaltkreis bekannt, bei dem unter einem Bondpad in mehreren Metallisierungslagen jeweils zwei kammförmige Leiterbahnen eines Kondensators angeordnet sind. Aus der US 5,751,065 ist ein integrierter Schaltkreis bekannt, bei dem unter einem Bondpad in einer Metallisierungslage eine mit Durchbrüchen versehene Metallbahn angeordnet ist, die als elektrisch leitende Verbindung zum Bondpad dient.

Aufgabe der vorliegenden Erfindung ist es daher, eine Halbleiterstruktur vorzustellen, die einen vereinfachten Herstellungsprozess ermöglicht, wobei es keine Einschränkung in der Verwendung von Halbleiterelementen, die unter dem Padmetall liegen dürfen, gibt.

Erfindungsgemäß wird die Aufgabe durch eine integrierte Halbleiterstruktur gelöst, bei der zumindest unterhalb der Fläche des Padmetalls, die Leiterbahnen der obersten beiden Metallschichten eine Vielzahl von Durchbrüchen aufweisen. Diese Durchbrüche können mit dem selben Material, aus dem die Isolationsschichten bestehen, gefüllt sein, wie beispielsweise Silziumdioxid oder Siliziumnitrid. Hierdurch wird eine zusätzliche Stabilisierung der Halbleiterstruktur erreicht.

Erfindungsgemäß wird eine Erhöhung der Stabilität der integrierten Halbleiterstruktur gegenüber auftretenden Drücken auch dadurch erreicht, dass die Leiterbahnen der obersten beiden Metallschichten derart zueinander angeordnet sind, dass die Durchbrüche der obersten Leiterbahnen versetzt zu den Durchbrüchen der darunterliegenden Leiterbahnen liegen.

Diese versetzte Anordnung gewährleistet ein hohes Maß an Dämpfung.

Der Erfindung liegt die Erkenntnis zugrunde, dass durch eine geschickte Anordnung (Layout) der obersten beiden Metallebenen, die direkt unterhalb des Padmetalls liegen, eine Dämpfungs- und Stabilisierungsstruktur ausgebildet werden kann, ohne dass der Herstellungsprozess der integrierten Halbleiterstruktur geändert werden muss. Weiterhin haben die Erfinder erkannt, dass, durch die erhöhte Stabilität dieser Halbleiterstruktur, jede Art von Halbleiterelement unterhalb der Fläche des Padmetalls angeordnet werden kann.

Die Leiterbahnen nach der vorliegenden Erfindung sind elektrisch nutzbar und dienen nicht nur der Stabilitätserhöhung. So haben die unter dem Padmetall verlaufenden Leiterbahnen einen Anschluss zu einem oder unterschiedlichen Potentialen auf der Halbleiterstruktur. Typischerweise werden die Leiterbahnen der obersten Metallschicht als Versorgungsleitungen für darunter liegende Halbleiterelemente (z. B. Transistoren) verwendet.

Je nach Technologie können die Anzahl der Metallschichten zwischen 3 und 11 liegen, beispielweise werden derzeit bei der 0,13 µm CMOS-Technologie zwischen 4 und 8 Metallschichten verwendet.

Eine Ausgestaltung der erfindungsgemäßen integrierten Halbleiterstruktur sieht vor, dass die Anzahl der Leiterbahnen, innerhalb einer Metallschicht, zumindest unterhalb der Fläche des Padmetalls, je nach Größe und Ausdehnung dieses Padmetalls, zwischen 2 und 6 liegen.

Erfindungsgemäß können innerhalb einer Metallschicht die Leiterbahnen elektrisch voneinander isoliert sein.

In einer Weiterentwicklung sind die Leiterbahnen innerhalb einer Metallschicht elektrisch miteinander verbunden. Darüber hinaus können innerhalb einer Metallschicht, bei Vorliegen von mehr als zwei Leiterbahnen unterhalb der Fläche des Padmetalls, einzelne Leiterbahnen elektrisch von den anderen Leiterbahnen isoliert sein, wobei die restlichen Leiterbahnen miteinander elektrisch verbunden sind.

Auch ist vorstellbar, dass, zumindest in kleinen Bereichen unterhalb der Fläche des Padmetalls, Strukturen eingebaut werden, sogenannte Dummystrukturen, die lediglich Stabilisierungsfunktionen haben, aber keine elektrische Anbindung an ein Potential besitzen. Allerdings führt diese Ausbildung zu einem Verlust an elektrisch nutzbarer Fläche.

Eine erfindungsgemäße Ausgestaltung, die die mechanische Belastung von den, unter den Padmetall liegenden Strukturen abschirmt, sieht vor, dass die Leiterbahnen hinreichend breit ausgeführt sind, sowie entspannte Abstände zueinander haben. Bei einer Ausgestaltung liegt das Verhältnis zwischen der Breite der Leiterbahnen und ihrem Abstand zueinander zwischen 3 und 20, vorzugsweise ist das Verhältnis 10. Zumindest die obersten beiden Metallschichten sind also als breite Leiterbahnen ausgeführt, um zwar einen Dämpfungseffekt zu erzielen, aber keine unnötige Prozessführung erforderlich zu machen.

In einer besonders vorteilhaften Weiterentwicklung der erfindungsgemäßen integrierten Halbleiterstruktur sind, zumindest unterhalb der Fläche des Padmetalls, eine Vielzahl von Vias vorgesehen, die die Leiterbahnen der obersten Metallschicht mit den Leiterbahnen der darunterliegenden Metallschicht elektrisch verbinden, wobei die Vias die Isolationsschicht zwischen den obersten beiden Metallschichten vertikal durchdringen. Dies gewährleistet zum einen, dass das Halbleiterelement auch bei einem eventuell auftretenden Kurzschluss zwischen diesen Metallschichten, wie es durch mechanischen Druck hervorgerufen werden kann, noch funktioniert. Auf der anderen Seite stabilisieren die Vias die integrierte Halbleiterstruktur zusätzlich.

Eine optimierte Stabilisierung und Dämpfung kann über eine geeignete Ausbildung der Vias erreicht werden. Bevorzugt wird unterhalb der Fläche des Padmetalls eine größere Anzahl von Vias zwischen den obersten beiden Metallschichten verteilt, wobei die Vias eine zueinander serielle Anordnung oder eine zueinander versetzte Anordnung aufweisen. Hierdurch wird auftretender Druck auf eine möglichst große Fläche verteilt.

In einer anderen Weiterentwicklung der erfindungsgemäßen integrierten Halbleiterstruktur weisen die Durchbrüche, zumindest unterhalb der Fläche des Padmetalls, eine Gesamtfläche zwischen 5% und 30% der Gesamtfläche der Leiterbahnen auf. Vorzugsweise enthalten die Leiterbahnen 20% an Durchbrüchen.

In einer anderen Ausbildung der erfindungsgemäßen integrierten Halbleiterstruktur liegen die Leiterbahnen der obersten Metallschicht ungefähr deckungsgleich über den Leiterbahnen der darunterliegenden Metallschicht.

Vorzugsweise liegen die Leiterbahnen der obersten Metallschicht versetzt zu den Leiterbahnen der darunter liegenden Metallschicht. Hierdurch wird eine sehr effektive Dämpfungsstruktur ausgebildet. Der seitliche Versatz der Leiterbahnen zueinander kann dabei maximal sein, wobei also zwei nebeneinanderliegende Leiterbahnen einer Metallschicht von der beispielsweise darüber liegenden Leiterbahn teilweise bedeckt werden.

Eine weitere vorteilhafte Ausgestaltung der integrierten Halbleiterstruktur sieht vor, dass die Metallschichten, zumindest großteils, aus einem hinreichend harten Metall bestehen. Hierdurch kann vermieden werden, dass sich bei mechanischer Belastung die Dicke der Metallschichten verringert oder die Isolationsschicht, die über der Metallschicht liegt, bis zur darunter liegenden Isolationsschicht durchgedrückt wird.

Typischerweise stellt das Metall Kupfer, Aluminium, Wolfram, Molybdän, Silber, Gold, Platin oder Legierungen hiervon dar.

In einer anderen Weiterbildung überdeckt die Fläche des Padmetalls einen Bereich, der, innerhalb einer Metallschicht, zumindest aus 50% Metall besteht. Hierzu zählen vorzugsweise die metallischen Bereiche der Leiterbahnen (ohne Durchbrüche), aber auch zusätzlich eingefügte metallische Dummystrukturen.

Für eine besonders stabile Ausgestaltung der integrierten Halbleiterstruktur ist das Metall gleichmäßig unterhalb der Fläche des Padmetalls verteilt. Vorzugsweise sind also die aus Metall bestehenden Leiterbahnen, sowie die Durchbrüche innerhalb der Leiterbahnen und die elektrische Verbindung zwischen nebeneinander liegenden Leiterbahnen gleichmäßig unter der Fläche des Padmetalls verteilt.

Vorzugsweise ist zwischen dem Padmetall und der obersten Metallschicht eine oberste Isolationsschicht vorgesehen, wobei die oberste Isolationsschicht eine erste Dicke D1 und die oberste Metallschicht eine zweite Dicke D2 aufweist, und das Verhältnis zwischen den beiden Dicken D1 und D2 zwischen 1 und 5 liegt. Hierdurch wird eine Verminderung der Gefahr von Rissen in der obersten Isolationsschicht und somit ein erhöhter Schutz der darunter liegenden Halbleiterelemente erreicht.

Eine andere Weiterentwicklung der erfindungsgemäßen integrierten Halbleiterstruktur sieht vor, dass die oberste Isolationsschicht eine Dicke D1 und das Padmetall eine Dicke D3 aufweist, und das Verhältnis zwischen den beiden Dicken D1 und D3 zwischen 0,5 und 3 liegt.

Die Erfindung wird nachstehend anhand der Figuren näher beschrieben. Es zeigen:
- Fig. 1: einen Querschnitt durch ein Ausführungsbeispiel ei- ner erfindungsgemäßen integrierten Halbleiterstruk- tur,
- Fig. 2: einen Ausschnitt der Leiterbahnen der obersten bei- den Metallschichten aus der Figur 1, in perspekti- vischer Darstellung
- Fig. 3: eine Draufsicht einer erfindungsgemäßen integrier- ten Halbleiterstruktur mit einem Padmetall und Lei- terbahnen.

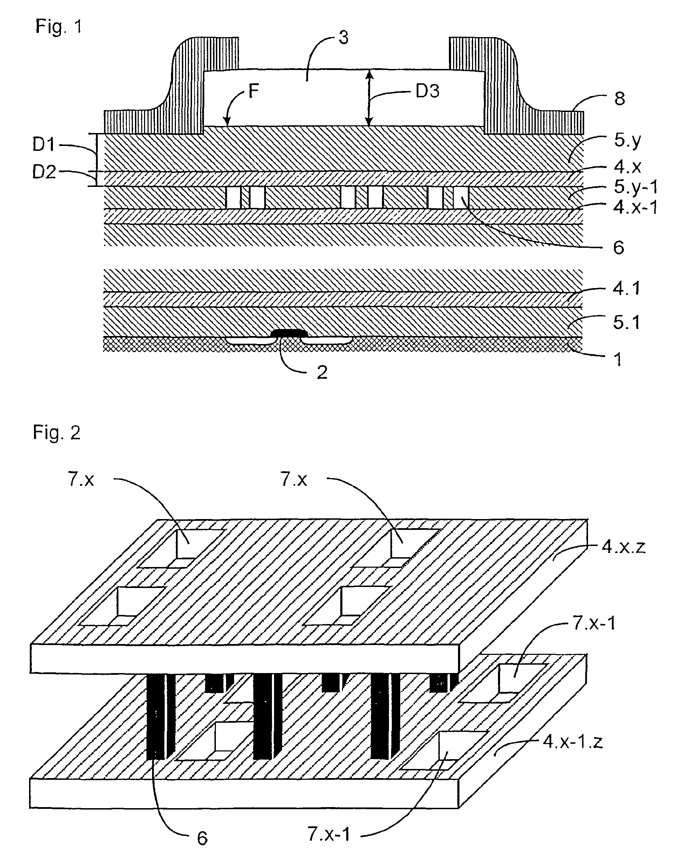

Die Halbleiterstruktur enthält ein Padmetall 3 mit einer Fläche F und einer Dicke D3, beispielsweise eine dicke Schicht aus Aluminium, eine Passivierung 8, ein Substrat 1, ein auf dem Substrat liegendes Halbleiterelement 2, beispielsweise ein Transistor 2, wobei der Transistor 2 unterhalb der Fläche F des Padmetalls 3 angeordnet ist, eine Vielzahl von Metallschichten 4.x, sowie eine Vielzahl von Isolationsschichten 5.y, die die Metallschichten 4.x voneinander trennen. Zur besseren Übersichtlichkeit zeigt die Figur 1 in einer schematischen Darstellung lediglich die erste und die obersten beiden Metallschichten 4.1, 4.x-1 und 4.x, wobei je nach verwendeter Technologie derzeit bis zu 11 Metallschichten 4.x übereinander angeordnet sein können.

Zur Abschirmung des mechanischen Druckes, der sich beim Bonden oder beim Testen der integrierten Halbleiterstruktur entwickelt, sind sowohl das Padmetall 3 als auch die oberste Isolationsschicht 5.y, die direkt unter dem Padmetall 3 liegt, hinreichend dick ausgestaltet. Die Isolationsschicht 5.y weist vorzugsweise eine Dicke D1 auf, die zwischen ein und fünf Mal so dick ist wie die Dicke D2 der obersten Metallschicht 4.x, und zwischen 0,5 und drei Mal so dick ist wie die Dicke D3 des Padmetalls 3.

Die obersten beiden Metallschichten 4.x und 4.x-1 sind durch eine Isolationsschicht 5.y-1 voneinander getrennt. Die Vias 6 durchdringen diese Isolationsschicht 5.y-1 vertikal und verbinden die oberste Metallschicht 4.x mit der darunterliegenden Metallschicht 4.x-1 elektrisch. Insbesondere im Bereich unterhalb der Fläche F des Padmetalls 3 sind eine Vielzahl von Vias 6 zwischen den beiden Metallschichten 4.x und 4.x-1 angeordnet. Diese Ausgestaltungen bewirken einen hinreichenden Schutz des Transistors 2 vor auftretenden mechanischen Belastungen.

Die Figur 2 zeigt, in perspektivischer Darstellung, einen Ausschnitt aus der erfindungsgemäßen integrierten Halbleiterstruktur im Bereich der obersten beiden Metallschichten direkt unterhalb der Fläche des Padmetalls. Sowohl die Leiterbahn 4.x.z der obersten Metallschicht, als auch die Leiterbahn 4.x-1.z der darunterliegenden Metallschicht weisen Durchbrüche 7.x und 7.x-1 auf. Die Durchbrüche 7.x der Leiterbahn 4.x.z sind zu den darunterliegenden Durchbrüchen 7.x-1 der Leiterbahn 4.x-1.z versetzt angeordnet. Die Durchbrüche 7.x und 7.x-1 liegen also nicht direkt übereinander. Darüber hinaus sind die beiden Leiterbahnen 4.x.z und 4.x-1.z über senkrecht verlaufende Vias 6 elektrisch miteinander verbunden. Um eine möglichst hohe Stabilität gegenüber Drücken zu gewährleisten, sind möglichst viele Vias 6, insbesondere im Bereich unterhalb des Padmetalls angeordnet.

Andere Anordnungen von Durchbrüche 7 x.und Vias 6 ergeben sich bei Anwendung der Kenntnisse und Fähigkeiten des Fachmanns.

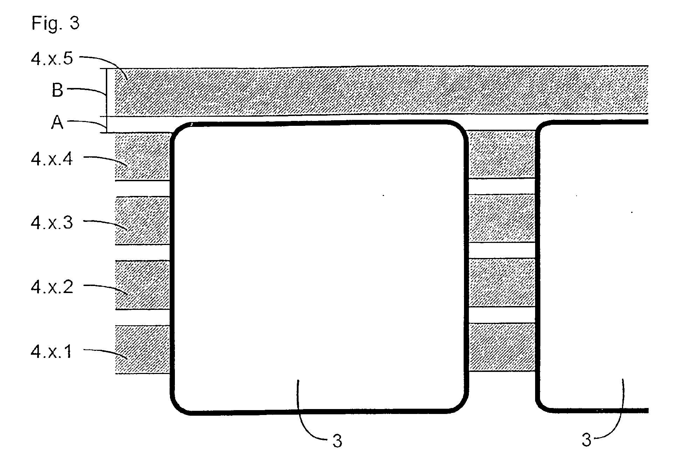

Die Figur 3 zeigt eine Draufsicht der erfindungsgemäßen integrierten Halbleiterstruktur mit einem Padmetall 3 sowie einem angrenzenden Padmetall 3. Im Bereich unterhalb der Padmetalle 3 verlaufen vier Leiterbahnen 4.x.1 bis 4.x.4. Die fünfte Leiterbahn 4.x.5 verläuft außerhalb des Bereiches der Padmetalle 3. Es sind deutlich die Abstände A zwischen den einzelnen Leiterbahnen 4.x.z und deren Breite B erkennbar. Halbleiterelemente, wie Transistoren oder Dioden liegen ebenfalls unter der Fläche des Padmetalls 3, sind jedoch in der Figur 3 nicht zu erkennen.

Insgesamt wird durch die Erfindung erreicht, dass auch ohne kostspielige Prozessänderungen oder Prozesserweiterungen, eine geeignete Dämpfungs- und Stabilisierungsstruktur vorgestellt wird, die ermöglicht, jede Art von elektrischen Halbleiterelementen unterhalb der Fläche des Padmetalls anzuordnen, ohne eine Beschädigung dieser Halbleiterelemente bei auftretenden Drücken, wie sie beim Bonden oder Testen entstehen, zu riskieren. Darüber hinaus kann nun der Bereich unterhalb der Fläche des Padmetalls, beispielsweise für Stromversorgungsbahnen, genutzt werden.

## Patentansprüche

1. Integrierte Halbleiterstruktur mit
einem Substrat (1),
mindestens einem auf dem Substrat (1) liegenden Halbleiterelement (2),
einem Padmetall (3) mit einer Fläche (F),
einer Vielzahl von Metallschichten (4.x), die zwischen dem Padmetall (3) und dem Substrat (1) liegen und
einer Vielzahl von Isolationsschichten (5.y), die die Metallschichten (4.x) voneinander trennen,
wobei das Padmetall (3) sich zumindest über einen Teil des mindestens einen Halbleiterelementes (2) erstreckt,
und wobei, unterhalb der Fläche (F) des Padmetalls (3), zumindest die obersten beiden Metallschichten (4.x, 4.x-1) eine Struktur aufweisen, die jeweils mindestens zwei nebeneinanderliegende Leiterbahnen (4.x.z, 4.x-1.z) enthalten, **dadurch gekennzeichnet, dass**, zumindest unterhalb der Fläche (F) des Padmetalls (3), die Leiterbahnen (4.x.z; 4.x-1.z) der obersten beiden Metallschichten (4.x, 4.x-1), eine Vielzahl von Durchbrüchen (7.x, 7.x-1) aufweisen,
und dass die Leiterbahnen (4.x.z, 4.x-1.z) der obersten beiden Metallschichten (4.x, 4.x-1) derart zueinander angeordnet sind, dass die Durchbrüche (7.x) der obersten Leiterbahnen (4.x.z) versetzt zu den Durchbrüchen (7.x-1) der darunter liegenden Leiterbahnen (4.x-1.z) liegen.

2. Halbleiterstruktur gemäß Anspruch 1, **dadurch gekennzeichnet, dass** die Anzahl z der Leiterbahnen (4.x.z) einer Metallschicht (4.x), unterhalb der Fläche (F) des Padmetalls (3), zwischen 2 und 6 liegt.

3. Halbleiterstruktur gemäß einem der voranstehenden Ansprüche, **dadurch gekennzeichnet, dass** innerhalb einer Metallschicht (4.x) die Leiterbahnen (4.x.z) elektrisch voneinander isoliert sind.

4. Halbleiterstruktur gemäß einem der voranstehenden Ansprüche, **dadurch gekennzeichnet, dass** innerhalb einer Metallschicht (4.x) die Leiterbahnen (4.x.z) elektrisch miteinander verbunden sind.

5. Halbleiterstruktur gemäß einem der voranstehenden Ansprüche, **dadurch gekennzeichnet, dass** innerhalb einer Metallschicht (4.x) die Leiterbahnen (4.x.z) eine Breite (B) und einen Abstand (A) zueinander aufweisen, wobei das Verhältnis zwischen der Breite (B) und dem Abstand (A) zwischen 3 und 20 liegt.

6. Halbleiterstruktur gemäß Anspruch 5, **dadurch gekennzeichnet, dass** das Verhältnis zwischen der Breite (B) und dem Abstand (A) 10 ist.

7. Halbleiterstruktur gemäß einem der voranstehenden Ansprüche, **dadurch gekennzeichnet, dass,** zumindest unterhalb der Fläche (F) des Padmetalls (3), eine Vielzahl von Vias (6) vorgesehen sind, die die Leiterbahnen (4.x.z) der obersten Metallschicht (4.x) mit den Leiterbahnen (4.x-1.z) der darunter liegenden Metallschicht (4.x-1) elektrisch verbinden, wobei die Vias (6) die Isolationsschicht (5.y-1) durchdringen.

8. Halbleiterstruktur gemäß einem der voranstehenden Ansprüche, **dadurch gekennzeichnet, dass,** zumindest unterhalb der Fläche (F) des Padmetalls (3), die Durchbrüche (7.x, 7.x-1) eine Gesamtfläche zwischen 5% und 30% der Gesamtfläche der Leiterbahnen (4.x.z, 4.x-1.z) aufweisen.

9. Halbleiterstruktur gemäß einem der voranstehenden Ansprüche, **dadurch gekennzeichnet, dass** die Durchbrüche (7.x, 7.x-1) eine Gesamtfläche von 20% der Gesamtfläche der Leiterbahnen (4.x.z, 4.x-1.z) aufweisen.

10. Halbleiterstruktur gemäß einem der voranstehenden Ansprüche, **dadurch gekennzeichnet, dass** die Leiterbahnen (4.x.z) der obersten Metallschicht (4.x) ungefähr deckungsgleich über den Leiterbahnen (4.x-1.z) der darunter liegenden Metallschicht (4.x-1) liegen.

11. Halbleiterstruktur gemäß einem der voranstehenden Ansprüche 1 bis 9, **dadurch gekennzeichnet, dass** die Leiterbahnen (4.x.z) der obersten Metallschicht (4.x) versetzt zu den Leiterbahnen (4.x-1.z) der darunter liegenden Metallschicht (4.x-1) liegen.

12. Halbleiterstruktur gemäß einem der voranstehenden Ansprüche, **dadurch gekennzeichnet, dass** die Metallschichten (4.x), zumindest großteils, aus einem hinreichend harten Metall bestehen.

13. Halbleiterstruktur gemäß Anspruch 12, **dadurchgekennzeichnet, dass** das Metall Aluminium, Kupfer, Wolfram, Molybdän, Silber, Gold, Platin oder Legierungen hiervon enthält.

14. Halbleiterstruktur gemäß einem der voranstehenden Ansprüche, **dadurch gekennzeichnet, dass** die Fläche (F) des Padmetalls (3) einen Bereich überdeckt, der, innerhalb einer Metallschicht (4.x), zumindest aus 50% Metall besteht.

15. Halbleiterstruktur gemäß Anspruch 14, **dadurch gekennzeichnet, dass** das Metall gleichmäßig unterhalb der Fläche (F) des Padmetalls (3) verteilt ist.

16. Halbleiterstruktur gemäß einem der voranstehenden Ansprüche, **dadurch gekennzeichnet, dass** eine oberste Isolationsschicht (5.y) vorgesehen ist, die zwischen dem Padmetall (3) und der obersten Metallschicht (4.x) liegt, wobei die oberste Isolationsschicht (5.y) eine erste Dicke (D1) und die oberste Metallschicht (4.x) eine zweite Dicke (D2) aufweist und das Verhältnis zwischen den beiden Dicken (D1, D2) zwischen 1 und 5 liegt.

17. Halbleiterstruktur gemäß einem der voranstehenden Ansprüche, **dadurch gekennzeichnet, dass** eine oberste Isolationsschicht (5.y) vorgesehen ist, die zwischen dem Padmetall (3) und der obersten Metallschicht (4.x) liegt, wobei die oberste Isolationsschicht (5.y) eine Dicke (D1) und das Padmetall (3) eine weitere Dicke (D3) aufweist und das Verhältnis zwischen den beiden Dicken (D1, D3) zwischen 0,5 und 3 liegt.

18. Halbleiterstruktur gemäß einem der voranstehenden Ansprüche, **dadurch gekennzeichnet, dass** die Anzahl x der Metallschichten (4.x) zwischen 3 und 11 liegt.

## Claims

1. An integrated semiconductor structure, having
a substrate (1),
at least one semiconductor element (2) located on the substrate (1),
a pad metal (3) having a surface (F),
a multiplicity of metal layers (4.x) which are located between the pad metal (3) and the substrate (1), and
a multiplicity of insulation layers (5.y), which separate the metal layers (4.x) from one another,
the pad metal (3) extending at least over part of the at least one semiconductor element (2),
and, below the surface (F) of the pad metal (3), at least the top two metal layers (4.x, 4.x-1) having a structure which in each case at least includes two adjacent interconnects (4.x.z, 4.x-1.z),
wherein, at least below the surface (F) of the pad metal (3), the interconnects (4.x.z 4.x-1.z) of the top two metal layers (4.x, 4.x-1) have a multiplicity of apertures (7.x, 7.x-1),
and wherein the interconnects (4.x.z, 4.x-1.z) of the top two metal layers (4.x, 4.x-1) are arranged in such a manner with respect to one another that the apertures (7.x) in the top interconnects (4.x.z) are offset with respect to the apertures (7.x-1) in the interconnects (4.x-1.z) below.

2. The semiconductor structure as claimed in claim 1, wherein the number z of the interconnects (4.x.z) of a metal layer (4.x), beneath the surface (F) of the pad metal (3), is between 2 and 6.

3. The semiconductor structure as claimed in one of the preceding claims, wherein the interconnects (4.x.z) within a metal layer (4.x) are electrically insulated from one another.

4. The semiconductor structure as claimed in one of the preceding claims, wherein the interconnects (4.x.z) within a metal layer (4.x) are electrically connected to one another.

5. The semiconductor structure as claimed in one of the preceding claims, wherein the interconnects (4.x.z) within a metal layer (4.x) have a width (B) and are at a spacing (A) from one another, the ratio between the width (B) and the spacing (A) being between 3 and 20.

6. The semiconductor structure as claimed in claim 5, wherein the ratio between the width (B) and the spacing (A) is 10.

7. The semiconductor structure as claimed in one of the preceding claims, wherein, at least below the surface (F) of the pad metal (3), there is a multiplicity of vias (6) which electrically connect the interconnects (4.x.z) of the top metal layer (4.x) to the interconnects (4.x-1.z) of the metal layer (9.x-1) below it, the vias (6) penetrating through the insulation layer (5.y-1).

8. The semiconductor structure as claimed in one of the preceding claims, wherein, at least below the surface (F) of the pad metal (3), the apertures (7.x, 7.x-1) have a total area of between 5% and 30% of the total area of the interconnects (4.x.z, 4.x-1.z).

9. The semiconductor structure as claimed in one of the preceding claims, wherein the apertures (7.x, 7.x-1) have a total area of 20% of the total area of the interconnects (4.x.z, 4.x-1.z).

10. The semiconductor structure as claimed in one of the preceding claims, wherein the interconnects (4.x.z) of the top metal layer (4.x) lie approximately congruently above the interconnects (4.x-1.z) of the metal layer (4.x-1) below.

11. The semiconductor structure as claimed in one of the preceding claims 1 to 9, wherein the interconnects (4.x.z) of the top metal layer (4.x) are offset with respect to the interconnects (4.x-1.z) of the metal layer (4.x-1) below.

12. The semiconductor structure as claimed in one of the preceding claims, wherein the metal layers (4.x), at least for the most part, are made from a sufficiently hard metal.

13. The semiconductor structure as claimed in claim 12, wherein the metal contains aluminum, copper, tungsten, molybdenum, silver, gold, platinum or alloys thereof.

14. The semiconductor structure as claimed in one of the preceding claims, wherein the surface (F) of the pad metal (3) covers a region which, within a metal layer (4.x), comprises at least 50% metal.

15. The semiconductor structure as claimed in claim 14, wherein the metal is distributed uniformly beneath the surface (F) of the pad metal (3).

16. The semiconductor structure as claimed in one of the preceding claims, wherein a top insulation layer (5.y) is provided between the pad metal (3) and the top metal layer (4.x), the top insulation layer (5.y) having a first thickness (D1) and the top metal layer (4.x) having a second thickness (D2), and the ratio between the two thicknesses (D1, D2) being between 1 and 5.

17. The semiconductor structure as claimed in one of the preceding claims, wherein a top insulation layer (5.y) is provided between the pad metal (3) and the top metal layer (4.x), the top insulation layer (5.y) having a thickness (D1) and the pad metal (3) having a further thickness (D3), and the ratio between the two thicknesses (D1, D3) being between 0.5 and 3.

18. The semiconductor structure as claimed in one of the preceding claims, wherein the number x of the metal layers (4.x) is between 3 and 11.

## Revendications

1. Structure à semi-conducteur intégrée comprenant
un substrat (1),
au moins un élément (2) à semi-conducteur,
un métal (3) pad ayant une surface (F),
une pluralité de couches (4.x) de métal, qui se trouve entre le métal (3) pad et le substrat (1) et
une pluralité de couches (5.y) isolantes, qui sépare les couches (4.x) de métal l'une de l'autre,
dans laquelle le métal (3) pad s'étend au moins sur une partie du au moins un élément (2) à semi-conducteur,
et dans laquelle, en dessous de la surface (F) du métal (3) pad, au moins les deux couches (4.x, 4.x-1) de métal les plus hautes ont une structure qui contient respectivement au moins deux pistes (4.x.z, 4.x-1.z) conductrices côte à côte,
**caractérisée en ce que,** au moins en dessous de la surface (F) du métal (3) pad, les pistes (4.x.z, 4.x-1.z) conductrices des deux couches (4.x, 4.x-1) de métal les plus hautes ont une pluralité de traversées (7.x, 7.x-1),
et **en ce que** les pistes (4.x.z, 4.x-1.z) conductrices des deux couches (4.x, 4.x-1) de métal les plus hautes sont disposées les unes par rapport aux autres de manière à ce que les traversées (7.x) des pistes (4.x.z) conductrices les plus hautes soient décalées par rapport aux traversées (7.x-1) des pistes (4.x-1.z) conductrices sous-jacentes.

2. Structure à semi-conducteur suivant la revendication 1, **caractérisée en ce que** le nombre z des pistes (4.x.z) conductrices d'une couche (4.x) métallique en dessous de la surface (F) du métal (3) pad est compris entre 2 et 6.

3. Structure à semi-conducteur suivant l'une des revendications précédentes, **caractérisée en ce que,** au sein d'une couche (4.x) métallique, les pistes (4.x.z) conductrices sont isolées électriquement les unes des autres.

4. Structure à semi-conducteur suivant l'une des revendications précédentes, **caractérisée en ce que,** au sein d'une couche (4.x) métallique, les pistes (4.x.z) conductrices sont reliées électriquement les unes aux autres.

5. Structure à semi-conducteur suivant l'une des revendications précédentes, **caractérisée en ce que**, au sein d'une couche (4.x) métallique, les pistes (4.x.z) conductrices ont une largeur (B) et une distance (A) les unes par rapport aux autres, le rapport entre la largeur (B) et la distance (A) étant compris entre 3 et 20.

6. Structure à semi-conducteur suivant la revendication 5, **caractérisée en ce que** le rapport entre la largeur (B) et la distance (A) est de 10.

7. Structure à semi-conducteur suivant l'une des revendications précédentes, **caractérisée en ce que,** au moins en dessous de la surface (F) du métal (3) pad, est prévue une pluralité de vias (6) qui relie électriquement les pistes (4.x.z) conductrices de la couche (4.x) de métal la plus haute aux pistes (4.x-1.z) conductrices de la couche (4.x-1) de métal sous-jacente, les vias (6) traversant la couche (5.y-1) isolante.

8. Structure à semi-conducteur suivant l'une des revendications précédentes, **caractérisée en ce que,** au moins en dessous de la surface (F) du métal (3) pad, les traversées (7.x, 7.x-1) ont une surface totale représentant entre 5 % et 30 % de la surface totale des pistes (4.x.z, 4.x-1.z) conductrices.

9. Structure à semi-conducteur suivant l'une des revendications précédentes, **caractérisée en ce que** les traversées (7.x, 7.x-1) ont une surface totale représentant 20 % de la surface totale des pistes (4.x.z, 4.x-1.z) conductrices.

10. Structure à semi-conducteur suivant l'une des revendications précédentes, **caractérisée en ce que** les pistes (4.x.z) conductrices de la couche (4.x) de métal la plus haute sont disposées à peu près en coïncidence au-dessus des pistes (4.x-1.z) conductrices de la couche (4.x-1) de métal sous-jacente.

11. Structure à semi-conducteur suivant l'une des revendications précédentes 1 à 9, **caractérisée en ce que** les pistes (4.x.z) conductrices de la couche (4.x) de métal la plus haute sont décalées par rapport aux pistes (4.x-1.z) conductrices de la couche (4.x-1) de métal sous-jacente.

12. Structure à semi-conducteur suivant l'une des revendications précédentes, **caractérisée en ce que** les couches (4.x) de métal sont au moins en grande partie en un métal suffisamment dur.

13. Structure à semi-conducteur suivant la revendication 12, **caractérisée en ce que** le métal contient de l'aluminium, du cuivre, du tungstène, du molybdène, de l'argent, de l'or, du platine ou leurs alliages.

14. Structure à semi-conducteur suivant l'une des revendications précédentes, **caractérisée en ce que** la surface (F) du métal (3) pad recouvre une partie qui, au sein d'une couche (4.x) métallique, est constituée de métal pour au moins 50 %.

15. Structure à semi-conducteur suivant la revendication 14, **caractérisée en ce que** le métal est réparti uniformément sous la surface (F) du métal (3) pad.

16. Structure à semi-conducteur suivant l'une des revendications précédentes, **caractérisée en ce qu'**il est prévu une couche (5.y) isolante la plus haute qui se trouve entre le métal (3) pad et la couche (4.x) de métal la plus haute, la couche (5.y) isolante la plus haute ayant une première épaisseur (D1) et la couche (4.x) de métal la plus haute ayant une deuxième épaisseur (D2) et le rapport entre les deux épaisseurs (D1, D2) est compris entre 1 et 5.

17. Structure à semi-conducteur suivant l'une des revendications précédentes, **caractérisée en ce qu'**il est prévu une couche (5.y) isolante la plus haute qui se trouve entre le métal (3) pad et la couche (4.x) de métal la plus haute, la couche (5.y) isolante la plus haute ayant une épaisseur (D1) et le métal (3) pad ayant une autre épaisseur (D3) et le rapport entre les deux épaisseurs (D1, D3) est compris entre 0,5 et 3.

18. Structure à semi-conducteur suivant l'une des revendications précédentes, **caractérisée en ce que** le nombre x des couches (4.x) de métal est compris entre 3 et 11.
